**Europäisches Patentamt**

**European Patent Office**

**Office européen des brevets**

(11) Veröffentlichungsnummer: **0 009 083**
A1

# EUROPÄISCHE PATENTANMELDUNG

(21) Anmeldenummer: 79102419.3

(22) Anmeldetag: 12.07.79

(51) Int. Cl.³: **H 03 K 19/092,** H 04 B 1/16

(30) Priorität: 19.09.78 DE 2840705

(43) Veröffentlichungstag der Anmeldung: 02.04.80
Patentblatt 80/7

(84) Benannte Vertragsstaaten: **FR GB NL**

(71) Anmelder: SIEMENS AKTIENGESELLSCHAFT Berlin
und München, Postfach 22 02 61, D-8000
München 22 (DE)

(72) Erfinder: **Wilhelm, Wilhelm, Dr., Geigenberger
Strasse 23, D-8000 München 71 (DE)**
Erfinder: **Trinkl, Wolfgang, Dipl.-Ing.,
Bruckerstrasse 75, D-8060 Dachau-Mitterndorf (DE)**
Erfinder: **Delker, Klaus, Geigenberger Strasse 21,
D-8000 München 71 (DE)**

(54) Schaltungsanordnung zum Wechseln des Bezugspotentials von logischen Signalen.

(57) Beim Übergang von CML-Schaltungen auf TTL-Schaltungen, für die nur eine gemeinsame Versorgungsspannung vorgesehen ist, muß das Bezugspotential gewechselt werden. Zur Transformation der Signale unter Berücksichtigung möglicher Schwankungen der Versorgungsspannung wird erfindungsgemäß eine Stromspiegel-Schaltung eingesetzt.

Die Erfindung wird vorzugsweise in hochintegrierten CML-Schaltungsanordnungen mit TTL-kompatiblen Signaleingängen und Signalausgängen angewandt.

SIEMENS AKTIENGESELLSCHAFT                Unser Zeichen
Berlin und München                        VPA 78 P 2 0 6 2 EUR

Schaltungsanordnung zum Wechseln des Bezugspotentials von
logischen Signalen.

Die Erfindung betrifft eine Schaltungsanordnung zum Wechseln
des Bezugspotentials von logischen Signalen gemäß dem Oberbegriff des Patentanspruchs.

Als Bezugspotential für die Bewertung von Signalpegeln in
Schaltungen zur Signalverarbeitung dient einer der beiden
Pole der Versorgungsspannung. Das ist bei Verknüpfungsgliedern der CML-Technik (CML = current-mode-logic) der
positive Pol, bei Verknüpfungsgliedern der TTL-Technik
(TTL = Transistor-Transistor-Logik) der negative Pol.
Nun findet häufig innerhalb von komplexen Schaltnetzen oder
Schaltwerken ein Wechsel der Schaltungstechnik statt. Bei
gleichzeitiger Verwendung von TTL- und C ML-Schaltungen werden gewöhnlich zwei Versorgungsspannungen vorgesehen, deren
gemeinsamer Pol das Bezugspotential für die Schaltungen beider Schaltungstechniken bildet. Ein Signalumsetzer muß dann
nur für für die entsprechende Verschiebung der Signalpegel
unter Berücksichtigung der unterschiedlichen Signalhübe sorgen.

She 1 Fdl/ 1. 9. 1978

In manchen Fällen ist jedoch die Bereitstellung von zwei Versorgungsspannungen unerwünscht. Dies gilt z. B. für LSI-Bausteine, die der höheren Schaltgeschwindigkeit wegen CML-Schaltungen enthalten, aber mit TTL-kompatiblen Eingängen und Ausgängen versehen sind. Es ist dann ein Wechsel des Bezugspotentials notwendig.

Der Erfindung liegt die Aufgabe zugrunde, eine Schaltungsanordnung zur Transformation und der auf dem positiveren Pol VCC der Versorgungsspannung bezogenen Signalpegel der CML-Schaltungen auf die auf den negativeren Pol VEE bezogenen Signalpegel der TTL-Schaltungen anzugeben. Die Transformation muß unabhängig von Schwankungen der Versorgungsspannung sein. Gemäß der Erfindung wird diese Aufgabe durch die Merkmale im kennzeichnenden Teil des Patentanspruchs gelöst.

Im folgenden wird die Erfindung anhand der Zeichnung näher beschrieben. Darin zeigt:
Fig. 1 eine schematische Darstellung der vorliegenden Potentialbeziehungen und
Fig. 2 ein Ausführungsbeispiel der Erfindung.

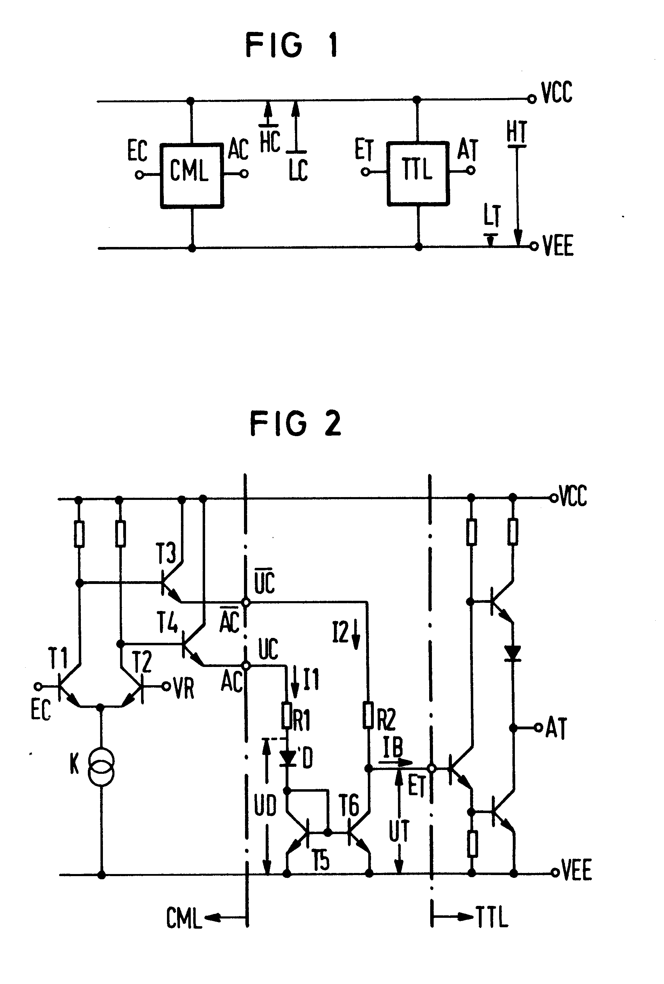

Nach Fig. 1 werden Schaltungsgruppen oder Einzelschaltungen CML in CML-Technik und TTL in TTL-Technik mit der Versorgungsspannung VCC-VEE betrieben. Der Abstand der beiden Versorgungsleitungen VCC und VEE ist ein Maß für die Größe der Versorgungsspannung, die im allgemeinen 5 V beträgt, aber gewissen Schwankungen unterworfen sein kann. Neben den Symbolen für die CML-Schaltungen CML und für die TTL-Schaltungen TTL mit den Signaleingängen $E_C$ bzw. $E_T$ und $A_C$[**] bzw. $A_T$ sind die typischen Signalpegel $H_C$ und $H_T$ bzw. $L_C$ und $L_T$ ungefähr maßstabsgerecht eingetragen. Die von den entsprechenden Potentialen ausgehenden Pfeile weisen auf die für die Bewertung der Signalpegel maßgeblichen Bezugspotentiale. Wie schon eingangs herausgestellt wurde, ist das für die
[**] den Signalausgängen

CML-Signale das Potential des positiven Pols VCC und für die TTL-Signale das Potential des negativen Pols VEE der Versorgungsspannung.

Um eine Verbindung zwischen der CML-Schaltung und der TTL-Schaltung herzustellen, wird also ein Zwischenglied benötigt, das die Signalpegel der CML-Schaltung in die entsprechenden Signalpegel der TTL-Schaltung auch dann richtig überführt, wenn die Versorgungsspannung von ihrem Sollwert abweicht. Wegen der Bindung der Signalpegel oder Signalpotentiale an verschiedene Bezugspotentiale entspricht das einem Wechsel der Bezugspotentiale.

Der linke Abschnitt der Fig. 2 zeigt als typischen Vertreter der Klasse der CML-Schaltungen einen Differenzverstärker in ECL-Technik mit den emittergekoppelten Transistoren T1 und T2. Die miteinander verbundenen Emitter der beiden Transistoren liegen über einer Konstantstromquelle K an dem negativen Pol VEE der Versorgungsspannung. An der Basis des einen Transistors T1 liegt das Eingangssignal $E_C$. Die Basis des anderen Transistors T2 ist an ein festes Referenzpotential VR angeschlossen. Die Ausgänge der ECL-Schaltung werden, wie üblich, durch die beiden Transistoren T3 und T4 in Emitterfolgerschaltung gebildet.

Zwischen den Ausgang $A_C$ der ECL-Schaltung und den negativen Pol VEE der Versorgungsspannung ist die Serienschaltung eines Widerstandes R1, einer in Durchlaßrichtung gepolten Diode D und der Kollektor-Emitter-Strecke eines Transistors T5 eingefügt. Die Basis und der Kollektor dieses Transistors sind miteinander verbunden. Zwischen dem zweiten Ausgang $\overline{A_C}$ und dem negativen Pol VEE der Versorgungsspannung liegt ein zweiter Widerstand R2 und die Kollektor-Emitter-Strecke eines weiteren Transistors T6. An den Verbindungspunkt des Widerstands R2 mit dem Kollektor des Transistors T6 ist der Eingang $E_T$ eines typischen TTL-In-

0009083

verters angeschlossen. An seinem Ausgang $A_T$ werden die Signale zur Ansteuerung von weiteren TTL-Schaltungen abgenommen.

Der mittlere Schaltungsabschnitt der in drei Abschnitte unterteilten Gesamtschaltung nach Fig. 2 ist unter der Bezeichnung Stromspiegel-Schaltung bekannt (vergl. Valvo Berichte, Band XIX, Heft 3, Seite 107 bis 114). Die durch die beiden Zweige der Teilschaltung fließenden Ströme I1 und I2 sind bis auf vernachlässigbare Unterschiede gleich, wenn die Transistoren T5 und T6 gleich ausgeführt sind und eine ausreichend hohe Stromverstärkung besitzen, was bei integrierten npn-Transistoren fast immer erfüllt ist . Unter der weiteren Voraussetzung, daß die Widerstände R1 und R2 gleich sind und sich alle Spannungen auf den negativen Pol VEE der Versorgungsspannung beziehen, gelten die folgenden Beziehungen.

Nimmt man zunächst an, daß das Potential am Eingang $E_C$ des ECL-Differenzverstärkers gleich dem Referenzpotential VR ist, dann sind auch die Spannungen UC und $\overline{UC}$ an den Ausgängen $A_C$ und $\overline{A_C}$ der ECL-Schaltung gleich. Damit sind auch die Spannungsabfälle über den Widerständen R1 und R2 gleich, was wiederum zur Folge hat, daß die Spannungen UD und UT gleich sind. Es gilt ferner UD = 2 x UBE, wenn UBE der Spannungsabfall an der Basis-Emitter-Diode eines Transistors ist. Das ist aus der Fig. 2 ohne weiteres ersichtlich. Eine Spannung UT von der Größe 2 UBE entspricht wegen der Serienschaltung von 2 Basis-Emitter-Strecken aber gerade dem Schwellpegel des TTL-Eingangs. Die Beziehung UT = 2UBE gilt auch dann, wenn sich die Versorgungsspannung und damit die Spannung UE = $\overline{UE}$ gegen VEE ändert. Zwar ändern sich auch die Spannungsabfälle an den Widerständen R1 und R2, jedoch in demselben Sinne und um den gleichen Betrag. Damit ist der Einfluß der Versorgungsspannung eliminiert.

Die Spannung UT spricht aber auf Unterschiede $\Delta$UV zwischen den Spannungen UC und $\overline{UC}$ an. Steigt die Spannung UC infolge einer Abweichung des Eingangspotential von dem Referenzpotential VR um den Betrag $\delta UC = \frac{\Delta UC}{2}$ an, dann vergrößert sich auch der Strom I1 entsprechend dem über dem Widerstand R1 nunmehr herrschenden Spannungsabfall. In gleicher Weise nimmt der Strom I2 und damit der Spannungsabfall über dem Widerstand R2 zu. Da die Spannung $\overline{UC}$ um den gleichen Betrag $\delta UC$ gesunken ist, vermindert sich die Spannung UT um $2\delta UC = \Delta UC$. Bei einer Umkehrung des Vorzeichens von $\Delta UC$ würde die Spannung UT um $\Delta UC$ ansteigen, wenn der TTL-Eingang nicht angeschlossen wäre. Tatsächlich erfolgt praktisch kein Spannungsanstieg mehr, vielmehr fließt in den TTL-Eingang nun ein Strom IB $\approx$ $\frac{0,8}{R2} \left[\frac{V}{\Omega}\right]$ hinein. Der TTL-Ausgang $A_T$ führt den niederen Signalpegel $L_T$, bezogen auf den negativen Pol VEE der Versorgungsspannung.

2 Figuren

1 Patentanspruch

0009083

## Liste der Bezugszeichen

VPA 78 P 2 0 6 2 EUR

| | |
|---|---|
| $H_C$ | Hoher CML-Signalpegel |
| $H_T$ | Hoher TTL-Signalpegel |
| $L_C$ | Niederer CML-Signalpegel |
| $L_T$ | ·Niederer TTL-Signalpegel |
| VCC | Positiver Pol der Versorgungsspannung |
| VEE | Negativer Pol der Versorgungsspannung |
| $E_C$ | Eingang der CML-Schaltung |
| $E_T$ | Eingang der TTL-Schaltung |
| $A_C$ | Ausgang der CML-Schaltung |
| $A_T$ | Ausgang der TTL-Schaltung |
| T1-T6 | Transistor |
| R1,R2 | Widerstand |
| D | Diode |

Patentanspruch

1. Schaltungsanordnung zum Wechsel des Bezugspotentials von logischen Signalen beim Übergang von CML-Schaltungen auf TTL-Schaltungen, wobei beide Schaltungsarten mit einer Versorgungsspannung VCC-VEE betrieben werden, d a d u r c h   g e k e n n z e i c h n e t, daß die CML-Schaltung zwei in an sich bekannter Weise durch Emitterfolger (T3, T4) gebildete Ausgänge ($A_C$, $\overline{A_C}$ ) für das invertierte und nichtinvertierte Ausgangssignal besitzt, daß zwischen dem Ausgang ($A_C$) für das nichtinvertierte Ausgangssignal und dem als Bezugspotential für die TTL-Schaltungen dienenden negativen Pol VEE der Versorgungsspannung ein erster Widerstand (R1), eine in Durchlaßrichtung gepolte Diode (D) und ein erster Transistor (T5), dessen Basis mit dem Kollektor verbunden ist, in Serie geschaltet sind, daß zwischen dem Ausgang ($\overline{A_C}$) für das invertierte Ausgangssignal und dem Bezugspotential für die TTL-Schaltungen ein zweiter Widerstand (R2) und ein zweiter Transistor (T6) in Serie geschaltet sind, daß an den Verbindungspunkt des zweiten Widerstands (R2) mit dem Kollektor des zweiten Transistors (T6) ein Inverter in TTL-Technik zur Bildung eines TTL-Signals angeschlossen ist und daß sowohl die Widerstände (R1, R2) als auch die Transistoren (T5, T6) gleich sind.

# FIG 1

# FIG 2

Europäisches
Patentamt

**EUROPÄISCHER RECHERCHENBERICHT**

0009083

Nummer der Anmeldung

EP 79 102 419.3

| Kategorie | EINSCHLÄGIGE DOKUMENTE Kennzeichnung des Dokuments mit Angabe, soweit erforderlich, der maßgeblichen Teile | betrifft Anspruch | KLASSIFIKATION DER ANMELDUNG (Int.Cl.3) |
|---|---|---|---|
| X | US - A - 4 045 690 (BURROUGHS CORP.) <br> * Spalte 1, Zeilen 27 bis 36; <br> Fig. 1, Positionen Q3, Q4, R2, Q2, R1, QD; Spalte 3, Zeilen 59 bis 63; <br> Spalte 4, Zeilen 20 bis 22; <br> Spalte 8, Zeilen 6 bis 9; <br> Spalte 3, Zeilen 28 bis 30 * <br> -- | Anspruch | H 03 K 19/092 <br> H 04 B 1/16 |
| A | US - A- 3 986 045 (ADVANCED MICRO DEVICES, INC.) <br> * ganzes Dokument * <br> -- | Anspruch | **RECHERCHIERTE SACHGEBIETE (Int. Cl.3)** <br><br> H 03 K 5/00 <br> H 03 K 19/08 |
| A | US - A - 3 974 402 (HONEYWELL INFOR- MATION SYSTEMS, INC.) <br> * ganzes Dokument * <br> -- | Anspruch | H 03 K 19/092 |
| A | US - A - 3 766 406 (COGAR CORP.) <br> * ganzes Dokument * <br> -- | Anspruch | |
| P,A | US - A - 4 140 977 (RCA CORP.) <br> * ganzes Dokument * | Anspruch | **KATEGORIE DER GENANNTEN DOKUMENTE** <br> X: von besonderer Bedeutung <br> A: technologischer Hintergrund <br> O: nichtschriftliche Offenbarung <br> P: Zwischenliteratur <br> T: der Erfindung zugrunde liegende Theorien oder Grundsätze <br> E: kollidierende Anmeldung <br> D: in der Anmeldung angeführtes Dokument <br> L: aus andern Gründen angeführtes Dokument <br> &: Mitglied der gleichen Patent- familie. übereinstimmendes Dokument |

| X | Der vorliegende Recherchenbericht wurde für alle Patentansprüche erstellt. | | |
|---|---|---|---|
| Recherchenort <br> Berlin | Abschlußdatum der Recherche <br> 24-09-1979 | Prüfer <br> ARENDT | |

EPA form 1503.1 06.78